# EUROPEAN PATENT APPLICATION

(11) **EP 1 096 563 A2**
(43) Date of publication of application: **02.05.2001**
(21) Application number: 00122170.4
(22) Date of filing: 12.10.2000
(51) Int. Cl.: H01L 23/04, H01L 23/10

(54) **Semiconductor package with premolded parts**

(30) Priority: 27.10.1999 JP 30500599
(71) Applicant: NEC CORPORATION, Tokyo (JP)
(72) Inventor: Sakai, Minoru, c/o NEC Corporation, Tokyo (JP); Yamamoto, Yasushi, Minato-ku Tokyo (JP); Kawahara, Hiroshi, Minato-ku Tokyo (JP)
(74) Representative: Betten & Resch

(57) **Abstract**

A protrusion (5a) is provided for positioning, thereby facilitating the positioning of the two elements (1,5) and enabling adhesion thereof without shifting of position between the resin cap (5) and the resin substrate (1), when a resin cap (5) and a resin substrate (1) are fitted together by adhering.

## Description

### BACKGROUND OF THE INVENTION

### 1. Field of the Invention

The present invention relates to a molded package, and more particularly to a molded package comprising a pre-molded resin substrate and a resin cap adhered thereto, which protects the surface of a chip mounted on the resin substrate, and mounted inside a hollow portion formed by the pre-molded resin substrate and a resin cap.

### 2. Related Art

In recent years, with the widespread use of consumer electronic equipment, there has arisen a desire for low-cost surface acoustic wave device. A method of achieving low cost that can be envisioned is a use of a synthetic resin in place of metal or ceramic for a package of a surface acoustic wave device. A past example of this type of package is disclosed in Japanese Patent No.2600689 and unexamined Japanese Utility Model (KOKAI) no.2-41512.

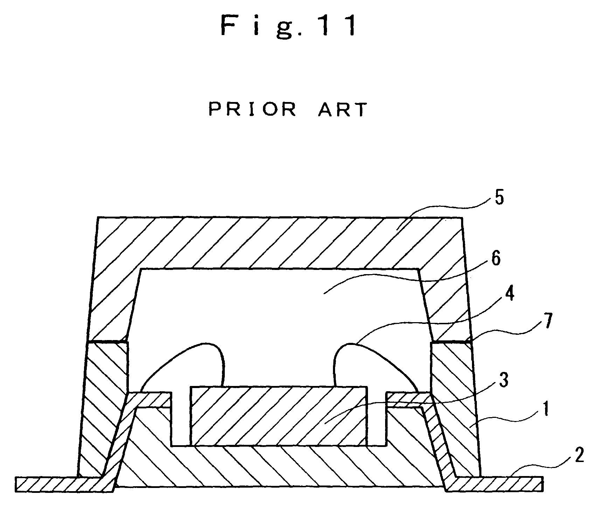

Referring to Fig. 11, the construction of a molded package for a surface acoustic wave device disclosed in above -mentioned Japanese Patent No.2600689 is one in which a resin substrate 1 and a resin cap 5 are adhered on a plane by the adhesive 7, thereby achieving airtight seal therebetween. In Fig. 11, the reference numeral 2 denotes a lead, 3 is a surface acoustic wave device chip, 4 is a metal wire, and 6 is a hollow portion formed inside a package.

The above structure, however, is accompanied by some problems.

The first problem is poor positioning accuracy at the adhering plane of the adhesive 7. The reason for this is that, because the positioning plane is flat, it is difficult to establish a positioning reference when the two elements 1,5 are mated together.

The second problem is that of a shift between the resin cap 5 and the resin substrate 1. The reason for this is that the positioning surfaces are flat, the flow of the adhesive 7 causes a shift when holding in place and, as a result, a fixture is required for holding, thereby increasing the manufacturing process steps.

Accordingly, it is an object of the present invention to provide a molded package wherein a resin substrate and a resin cap are adhered together with good accuracy, thereby enabling an improvement in productivity and a reduction in manufacturing cost.

### SUMMARY OF THE INVENTION

To achieve the above-noted object, the present invention has the following basic technical constitution.

Specifically, the first aspect of present invention is a molded package comprising a resin substrate 1, a resin cap 5 adhered thereto and a hollow portion 6 formed by the resin substrate 1 and the resin cap 5, so as to protect a surface 3a of a chip 3 mounted onto the resin substrate 1 by the hollow portion 6, wherein a protrusion 5a(or 1a) for positioning the resin substrate 1 and the resin cap 5 is provided on at least one adhering surface of the resin substrate 1 and the resin cap 5.

In the second aspect of present invention, the positioning protrusion 5a is provided so that a surface 5a' of the protrusion 5 makes contact with an inner surface of one of the resin substrate and the resin cap.

In the third aspect of present invention, the positioning protrusion is provided so that a surface of the protrusion makes contact with an outer surface of one of the resin substrate and the resin cap.

In the fourth aspect of present invention, the protrusion is provided along an outer edge of the adhering surface.

In the fifth aspect of present invention, the protrusion is provided along an inner edge of the adhering surface.

The action of the present invention is as follows. By providing a protrusion for positioning on an adhering surface of the resin cap or resin substrate, it is possible to position the two elements using the protrusion as a reference. By doing this, it is possible to reduce the positioning shift when holding the elements in place, and to achieve a good production yield.

### BRIEF DESCRIPTION OF THE DRAWINGS

Fig. 1(a) and Fig. 1(b) are cross-sectional views showing an embodiment of the present invention.
Fig. 2 is a cross-sectional view showing another embodiment of the present invention.
Fig. 3 is a plan view showing an example of a resin cap of the embodiment shown in Fig. 1.
Fig. 4 is a plan view showing another example of a resin cap of the embodiment shown in Fig. 1.
Fig. 5 is a plan view showing different example of a resin cap of the embodiment shown in Fig. 1.
Fig. 6 is a plan view showing yet another example of a resin cap of the embodiment shown in Fig. 1.
Fig. 7 is a plan view showing still another example of a resin cap of the embodiment shown in Fig. 1.
Fig. 8 is a plan view showing another example of a resin cap of the embodiment shown in Fig. 1.
Fig. 9 is a cross-sectional view showing another embodiment of the present invention.
Fig. 10 is a cross-sectional view showing another embodiment of the present invention.
Fig. 11 is a cross-sectional view showing an example of a molded package of the prior art.

### DETAILED DESCRIPTION OF THE PREFERRED EMBODIMENTS

Preferred embodiments of the present invention are described in detail below, with reference being made to relevant accompanying drawings.

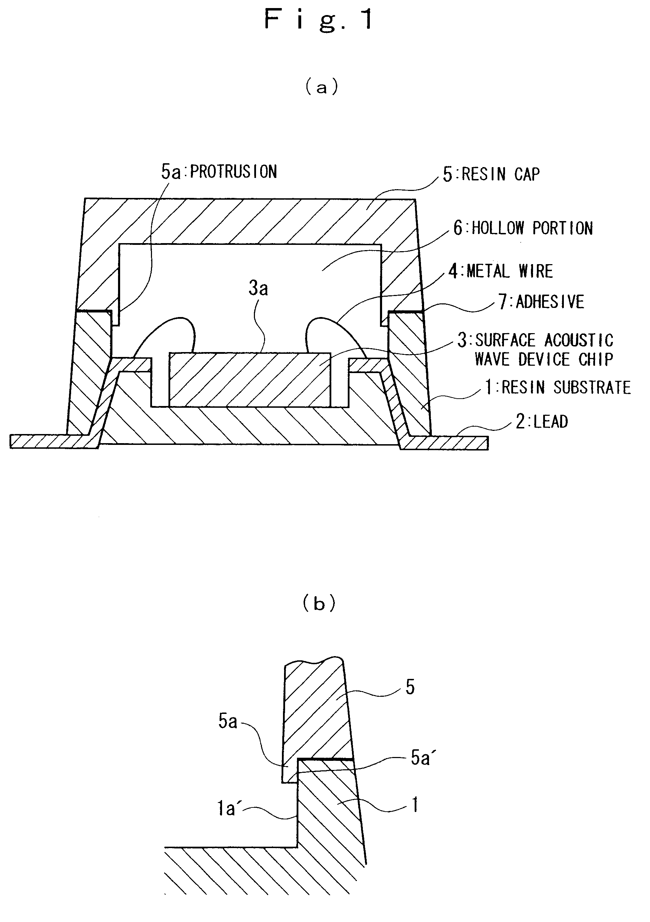

Specifically, Fig. 1 is a cross-sectional view showing an embodiment of the present invention, in which elements corresponding to elements in Fig. 11 are assigned the same reference numerals. Referring to Fig. 1, a resin substrate 1 pre-molded with a lead frame with a plurality of leads 2 and a resin cap 5 for protecting the surface of a surface acoustic wave chip 3 by a hollow part 6 and having positioning protrusions 5a provided along by an inner edge of the adhering surface are adhered together by an adhesive 7, thereby achieving an airtight construction. Other aspects of the configuration are the same as the example of Fig. 11, and are therefore not explicitly described herein.

When adhering the resin substrate 1 and the resin cap 5, by using the positioning protrusions 5a, the action of the protrusions 5a causes a mating between the two elements 1,5, so that there is correct joining therebetween, without a mutual shifting of the adhering surfaces. In this embodiment, as shown in the drawing, the protrusions 5a are provided along the peripheral edge of the adhering surface, the protrusions are provided at locations so that when fitting the two elements together, the surfaces 5a' of the protrusions 5a come into contact with the inner peripheral surface 1a' of the resin substrate 1.

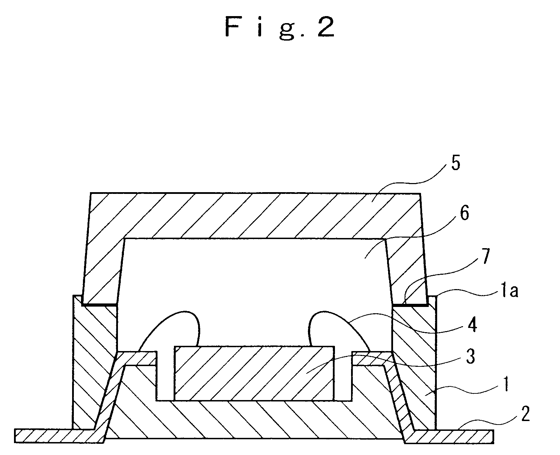

Fig. 2 shows another embodiment of the present invention, in which the same elements as shown in Fig. 11 are assigned the same reference numerals. In this embodiment, positioning protrusions 1a are provided on the resin substrate 1. The protrusions 1a are provided along the outer edge of the adhering surface, at locations such that when the two elements are fitted together the protrusions 1a come into contact with the outer peripheral surface of the resin cap 5. Other aspects of the configuration are the same as the embodiment shown in Fig. 1, and are not explicitly described herein.

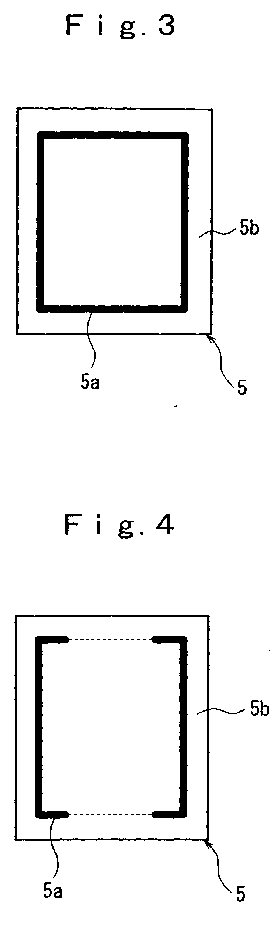

Fig. 3 is a plan view of a resin cap 5 of the embodiment shown in Fig. 1, in which a protrusion 5a is provided so as to extend over the entire inner edge of the adhering surface of the resin cap 5. In this case, the cross-sectional view would be the same as Fig. 1.

Fig. 4 is a plan view of a variation of the resin cap 5, in which protrusions 5a are provided so as to extend over the entire of the long sides and parts of the short sides of the resin cap 5.

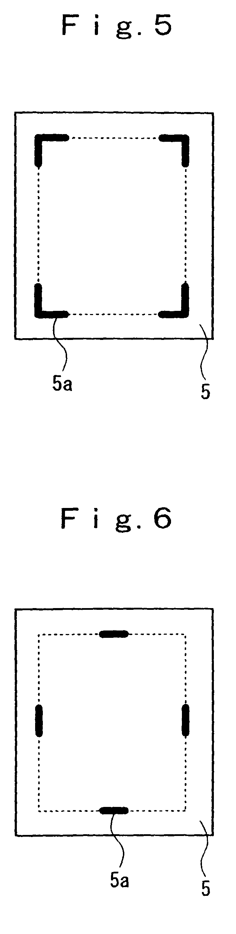

Fig. 5 is a plan view of another variation of the resin cap 5, in which protrusions 5a are provided at each corner of the resin cap 5.

Fig. 6 is a plan view of a different variation of the resin cap 5, in which protrusions 5a are provided at the center parts of each of the sides of the resin cap 5.

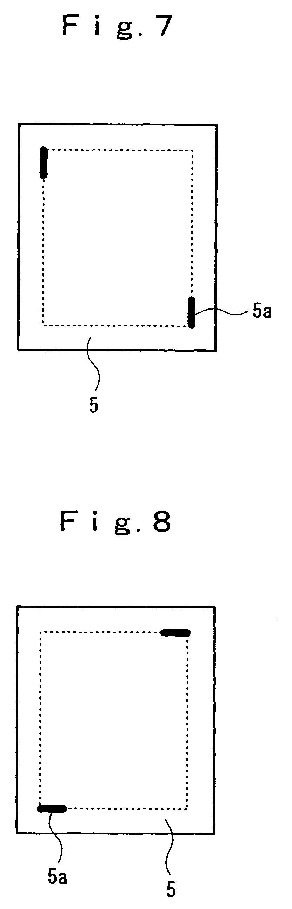

Fig. 7 is yet another variation of the resin cap 5, wherein protrusions 5a are provided at diagonally opposed positions on the long sides of the resin cap 5.

Fig. 8 is yet another variation of the resin cap 5, wherein protrusions 5a are provided at diagonally opposite positions on the short sides of the resin cap 5.

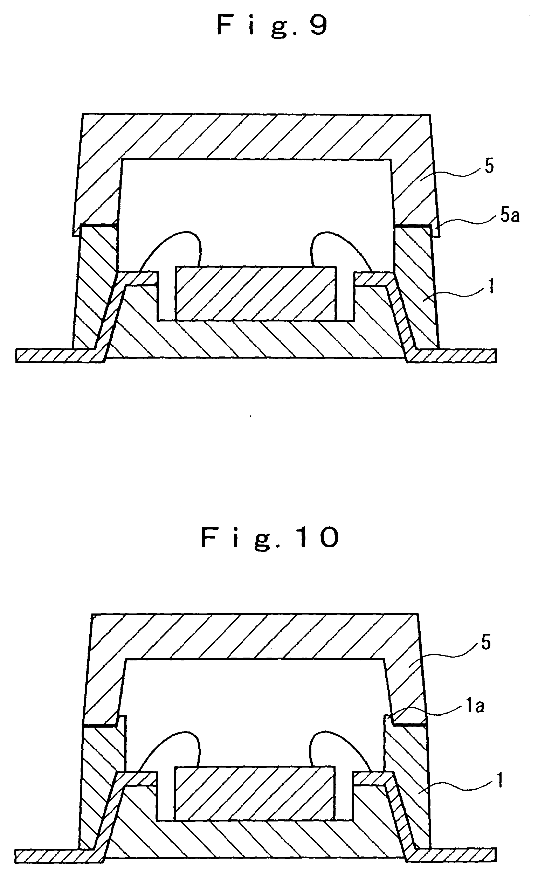

Fig. 9 is another variation of the present invention. In this embodiment, protrusions 5a are provided along the outer edge of the adhering surface of the resin cap 5.

Fig. 10 is another variation of the present invention. In this embodiment, protrusions 1a are provided along the inner edge of the adhering surface of the resin substrate 5.

The protrusions 5a shown in Fig. 3 to Fig. 8 can, if necessary, be provided in different positions than the positions shown in these drawings. While in the above-noted examples, the protrusions are provided along the outer edge or inner edge of the adhering surface, the protrusions can alternately be provided in the substantially center part of the adhering surface, in which case on the adhering surface a protruding part is provided on one side and a depression part is provided on the other side, these parts being provided at locations that enable the protruding part and the depression part to mutually fit together.

The present invention achieves several effects, one of which is that, by providing a protrusion for positioning when fitting the resin cap and resin substrate together, the adhering positioning accuracy is improved. The reason for this is that it is possible to perform positioning by means of the protrusions. Another effect achieved by the present invention is that of eliminating shifting in position when the resin cap and the resin substrate are adhered and held together. The reason for this is that, in the same manner, positioning is possible by means of the protrusions.

## Claims

1. A molded package comprising a resin substrate (1), a resin cap (5) adhered thereto and a hollow portion (6) formed by said resin substrate and said resin cap, so as to protect a surface of a chip mounted onto said resin substrate by said hollow portion, wherein a protrusion (5a) for positioning said resin substrate and said resin cap is provided on at least one adhering surface of said resin substrate and said resin cap.

2. A molded package according to claim 1, wherein said positioning protrusion (5a) is provided so that a surface of said protrusion makes contact with an inner surface of one of said resin substrate and said resin cap.

3. A molded package according to claim 1, wherein said positioning protrusion (5a) is provided so that a surface of said protrusion makes contact with an outer surface of one of said resin substrate and said resin cap.

4. A molded package according to claim 1, wherein said protrusion is provided along an outer edge of said adhering surface.

5. A molded package according to claim 1, wherein said protrusion is provided along an inner edge of said adhering surface.

6. A molded package according to claim 1, wherein said chip is a surface acoustic wave device.
